# EUROPEAN PATENT APPLICATION

(11) **EP 4 236 065 A1**
(43) Date of publication of application: **30.08.2023**
(21) Application number: 21902072.4
(22) Date of filing: 17.08.2021
(51) Int. Cl.: H03F 1/02

(54) **CASCODE STRUCTURE, OUTPUT STRUCTURE, AMPLIFIER AND DRIVING CIRCUIT**

(30) Priority: 07.12.2020 CN 202011438840
(71) Applicant: Changxin Memory Technologies, Inc., Hefei, Anhui 230601 (CN)
(72) Inventor: ZHU, Lei, Shanghai 200051 (CN)
(74) Representative: V.O.
(86) International application number: PCT/CN2021/113101
(87) International publication number: WO 2022/121362

(57) **Abstract**

A cascode structure, an output structure, an amplifier and a driving circuit are provided. A bias voltage of a common-gate structure in the cascode structure is provided by the cascode structure, bias voltages of transistors in the output structure are all provided by the output structure, the amplifier includes the cascode structure and/or the output structure described above, the driving circuit includes the amplifier described above. The amplifier circuit provided by the embodiments of the disclosure may achieve voltage amplification without providing a bias circuit.

## Description

### CROSS-REFERENCE TO RELATED APPLICATION

The disclosure claims priority to Chinese Patent Application No. 202011438840.8, filed on December 7, 2020 and entitled "CASCODE STRUCTURE, OUTPUT STRUCTURE, AMPLIFIER, AND DRIVING CIRCUIT", the disclosure of which is hereby incorporated by reference in its entirety.

### TECHNICAL FIELD

The disclosure relates to the field of integrated circuits, and particularly to a cascode structure, an output structure, an amplifier and a driving circuit in which a bias voltage is provided.

### BACKGROUND

An amplifier is typically used in a driving circuit. A structure of the amplifier generally includes a differential input stage, an intermediate amplifier stage, an output stage, and a bias circuit that provides bias voltages for the differential input stage, the intermediate amplifier stage and the output stage. The bias circuit is an indispensable part of the existing amplifier technology, but the bias circuit may increase the power consumption of the circuit.

It is to be noted that information disclosed in the background part is only used to enhance the understanding of the background of the disclosure, and thus may include information that does not constitute the prior art known by those of ordinary skill in the art.

### SUMMARY

The disclosure aims to provide a cascode structure, an output structure, an amplifier and a driving circuit, for overcoming the problem of high power consumption in the circuit caused by a bias circuit at least to a certain extent.

A first aspect of the disclosure provides a cascode structure in which a bias voltage of a common-gate structure is provided by the cascode structure. The cascode structure has a first node, a second node, a third node, a fourth node and a fifth node.

A second aspect of the disclosure provides an amplifier including the cascode structure as described above. The fourth node and the fifth node in the cascode structure respectively serve as a first input port and a second input port of the amplifier. The amplifier further includes a current source including two ports. A first port of the current source is connected to the third node. The amplifier further includes a load structure including four ports. A first port of the load structure is connected to the first node, the second port of the load structure is connected to the second node, and the second port of the load structure serves as an output port of the amplifier.

A third aspect of the disclosure provides an output structure in which bias voltages of transistors are all provided by the output structure. The output structure includes a first node, a second node, a sixth node, a seventh node, an eighth node, and a ninth node.

A fourth aspect of the disclosure provides an amplifier, which includes: the output structure as described above, an output port of the output structure serving as the output port of the amplifier; an input structure including five ports, a first output port and a second output port of the input structure being connected to the output structure, and a first input port and a second input port of the input structure respectively serving as the first input port and the second input port of the amplifier; a current source, including two ports, a first port of the current source being connected to a fifth port of the input structure.

A fifth aspect of the disclosure provides a driving circuit, including: a first amplifier, which is the amplifier as described above, a first input terminal of the first amplifier being connected to a first reference voltage, and a second input terminal of the first amplifier being connected to a tenth node; a second amplifier, which is the amplifier as described above, a first input terminal of the second amplifier being connected to a second reference voltage, a second input terminal of the second amplifier being connected to the tenth node; a first driving transistor, a gate of which is connected to an output terminal of the first amplifier, a source of which is connected to a power supply, a drain of which is connected to the tenth node; a second driving transistor, a gate of which is connected to an output terminal of the second amplifier, a source of which is grounded, and a drain of which is connected to the tenth node, the tenth node serving as an output terminal of the driving circuit.

In the embodiments of the disclosure, the bias voltage of the transistor in the amplifier is provided by the transistor. Therefore, a voltage amplification function is realized without adding an external bias circuit, that is, the power consumption of the amplifier is reduced.

It is to be understood that the above general description and the following detailed description are only exemplary and explanatory, and cannot limit the disclosure.

### BRIEF DESCRIPTION OF THE DRAWINGS

The drawings herein are incorporated into the specification and constitute a part of the specification, and show embodiments in accordance with the disclosure, and together with the specification, are used to explain the principle of the disclosure. Apparently, the drawings in the following description are only some embodiments of the disclosure. For those of ordinary skill in the art, other drawings may further be obtained based on these drawings without creative work.
FIG. 1A and FIG. 1B are schematic structural diagrams of a cascode structure in exemplary embodiments of the disclosure.
FIG. 2 is a schematic structural diagram of an amplifier composed of the cascode structure shown in FIG. 1A or FIG. 1B.
FIG. 3 is a schematic diagram of a load structure in an embodiment of the disclosure.
FIG. 4 is a schematic diagram of a load structure in another embodiment of the disclosure.
FIG. 5 is a schematic diagram of an output structure provided by an embodiment of the disclosure.
FIG. 6 is a schematic diagram of an amplifier in which the output structure shown in FIG. 5 is applied.
FIG. 7 is a schematic diagram of an embodiment of the amplifier shown in FIG. 6.
FIG. 8 is a schematic diagram of another embodiment of the amplifier shown in FIG. 6.
FIG. 9 is a schematic diagram of a driving circuit provided by an embodiment of the disclosure.
FIG. 10 is a schematic circuit diagram of a first driving transistor and a second driving transistor in an embodiment of the disclosure.
FIG. 11 is a schematic diagram of a driving circuit in an embodiment of the disclosure.
FIG. 12 is a schematic diagram of a driving circuit in yet another embodiment of the disclosure.

### DETAILED DESCRIPTION

Exemplary embodiments are now described more fully with reference to the accompanying drawings. However, the exemplary embodiments can be implemented in various forms, and should not be limited to the examples set forth herein. On the contrary, these embodiments are provided to make the disclosure comprehensive and complete, and fully convey the concept of the exemplary embodiments to those skilled in the art. The described features, structures or characteristics may be combined in one or more embodiments in any suitable way. In the following description, many specific details are provided to give a sufficient understanding of the embodiments of the disclosure. However, those skilled in the art will realize that the technical solutions of the disclosure may be practiced without providing one or more of the specific details, or other methods, components, devices, steps, or the like may be adopted. In other cases, the well-known technical solutions are not shown or described in detail in order to avoid obscuring all aspects of the disclosure.

Further, the drawings are only schematic illustrations of the disclosure, and the same reference numerals in the drawings indicate the same or similar parts, and thus their repeated description is omitted. Some of the block diagrams shown in the drawings are functional entities and do not necessarily correspond to physically or logically independent entities. These functional entities may be implemented in the form of software, or implemented in one or more hardware modules or integrated circuits, or implemented in different networks and/or processor devices and/or micro-controller devices.

The exemplary embodiments of the disclosure are described in detail below with reference to the accompanying drawings.

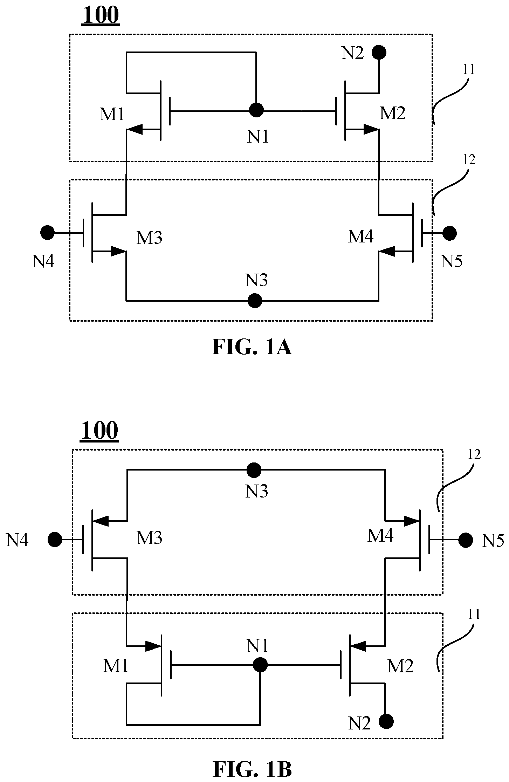

FIG. 1A and FIG. 1B are schematic structural diagrams of a cascode structure in exemplary embodiments of the disclosure.

Referring to FIG. 1A and FIG. 1B, a bias voltage of a common-gate structure 11 in a structure 100 is provided by the structure. The structure includes a first node N1, a second node N2, a third node N3, a fourth node N4, and a fifth node N5.

In the embodiment shown in FIG. 1A and FIG. 1B, the structure 100 includes the common-gate structure 11 and a common-source structure 12. The common-gate structure 11 includes a first transistor M1 and a second transistor M2. A gate and a drain of the first transistor M1 and a gate of the second transistor M2 are all connected to the first node N1, and a drain of the second transistor M2 is connected to the second node N2. The common-source structure 12 includes a third transistor M3 and a fourth transistor M4. A drain of the third transistor M3 is connected to a source of the first transistor M1, and a drain of the fourth transistor M4 is connected to a source of the second transistor M2. A source of the third transistor M3 and a source of the fourth transistor M4 are both connected to the third node N3, a gate of the third transistor M3 is connected to the fourth node N4, and a gate of the fourth transistor M4 is connected to the fifth node N5.

The first transistor M1, the second transistor M2, the third transistor M3, and the fourth transistor M4 are of the same type, and are N-type transistors (as shown in FIG. 1A) or P-type transistors (as shown in FIG. 1B).

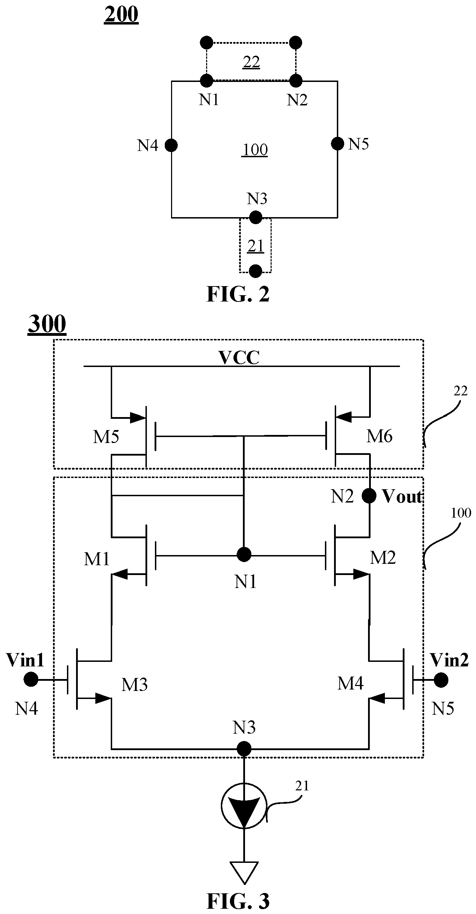

FIG. 2 is a schematic structural diagram of an amplifier composed of the cascode structure shown in FIG. 1A or FIG. 1B.

Referring to FIG. 2, the amplifier 200 may include the cascode structure 100, a current source 21, and a load structure 22.

The fourth node N4 and the fifth node N5 in the cascode structure 100 respectively serve as a first input port and a second input port of the amplifier 200.

The current source 21 includes two ports, and a first port of the current source 21 is connected to the third node N3.

The load structure 22 includes four ports. A first port of the load structure 22 is connected to the first node N1, a second port of the load structure is connected to the second node N2, and the second port of the load structure 22 serves as an output port of the amplifier 200.

In an exemplary embodiment of the disclosure, the transistor type of the current source 21 is the same as that of the cascode structure 100.

FIG. 3 is a schematic diagram of a load structure in an embodiment of the disclosure.

Referring to FIG. 3, in an exemplary embodiment of the disclosure, the load structure 22 may include a fifth transistor M5 and a sixth transistor M6.

A gate and a drain of the fifth transistor M5 are both connected to a gate of the sixth transistor M6, the drain of the fifth transistor M5 serves as the first port of the load structure 22, and a drain of the sixth transistor M6 serves as the second port of the load structure 22, a source of the fifth transistor M5 serves as a third port of the load structure 22, and a source of the sixth transistor M6 serves as a fourth port of the load structure 22.

In the embodiments of the disclosure, the transistor type of the load structure 22 is different from that of the cascode structure 100.

In the embodiment shown in FIG. 3, a second port of the current source 21 is grounded, and the third port and the fourth port of the load structure 22 are both connected to a power source VCC. In this case, the fifth transistor M5 and the sixth transistor M6 in the load structure 22 are both P-type transistors, and the first transistor M1, the second transistor M2, the third transistor M3, and the fourth transistor M4 in the cascode structure 100 are all N-type transistors.

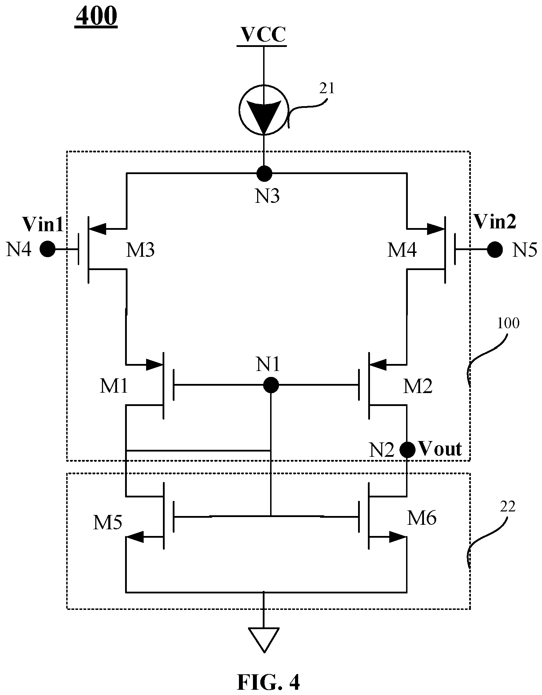

FIG. 4 is a schematic diagram of a load structure in another embodiment of the disclosure.

In the embodiment 400 shown in FIG. 4, the second port of the current source 21 is connected to the power supply VCC, and the third port and the fourth port of the load structure 22 are both grounded. In this case, the fifth transistor M5 and the sixth transistor M6 in the load structure 22 are both N-type transistors, and the first transistor M1, the second transistor M2, the third transistor M3, and the fourth transistor M4 in the cascode structure 100 are all P-type transistors.

In the embodiment shown in FIG. 3 and FIG. 4, the fourth node N4 and the fifth node N5 of the cascode structure 100 serve as two input ports of the amplifier, which may be connected to a first input voltage Vin1 and a second input voltage Vin2. The first input voltage Vin1 and the second input voltage Vin2 may be differential mode inputs or common mode inputs. The second node N2 as the output terminal Vout of the amplifier is the drain of the second transistor M2 which is connected to the common-gate. Therefore, a higher voltage gain can be achieved.

Since bias voltages of transistors in each of the amplifiers 200, 300 and 400 are all provided by an amplifier circuit, the amplifiers 200, 300, and 400 may achieve voltage amplification without providing a bias circuit, and implement lower power consumption.

The embodiments of the disclosure further provide an output structure in which bias voltages of transistors are all provided by the output structure.

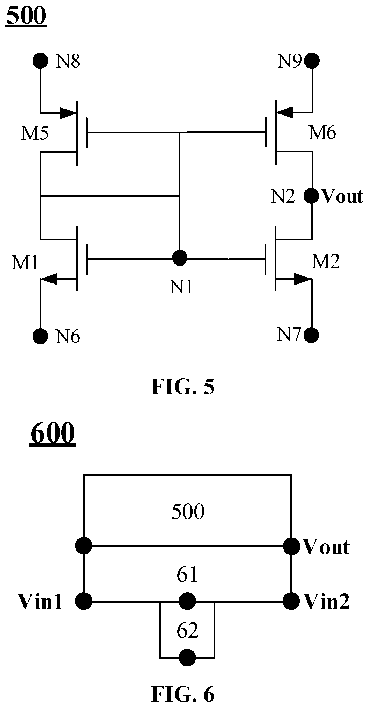

FIG. 5 is a schematic diagram of an output structure according to an embodiment of the disclosure.

Referring to FIG. 5, an output structure 500 includes a first node N1, a second node N2, a sixth node N6, a seventh node N7, an eighth node N8 and a ninth node N9.

The output structure 500 includes: a first transistor M1, a second transistor M2, a fifth transistor M5, and a sixth transistor M6.

A gate of the first transistor M1, a gate of the second transistor M2, a gate of the third transistor M3, a gate of the fourth transistor M4, a drain of the first transistor M1, and a drain of the fifth transistor M5 are all connected to the first node N1, a drain of the second transistor M2 and a drain of the sixth transistor M6 are both connected to the second node N2, a source of the first transistor M1 is connected to the sixth node N6, and a source of the second transistor M2 is connected to the seventh node N7, a source of the fifth transistor M5 is connected to the eighth node N8, a source of the sixth transistor M6 is connected to the ninth node N9, and the second node N2 serves as an output port Vout of the output structure.

The first transistor M1 and the second transistor M2 are N-type transistors, and the fifth transistor M5 and the sixth transistor M6 are P-type transistors.

FIG. 6 is a schematic diagram of an amplifier to which the output structure shown in FIG. 5 is applied.

Referring to FIG. 6, an amplifier 600 may include the output structure 500, an input structure 61 and a current source 62.

The output port Vout of the output structure 500 serves as an output port of the amplifier 600.

The input structure 61 includes five ports, a first output port and a second output port of the input structure 61 are connected to the output structure 500, and a first input port (the fourth node N4) and a second input port (the fifth node N5) of the input structure 61 respectively serve as a first input port and a second input port of the amplifier 600.

The current source 62 includes two ports, and a first port of the current source 62 is connected to a fifth port (the third node N3) of the input structure 61.

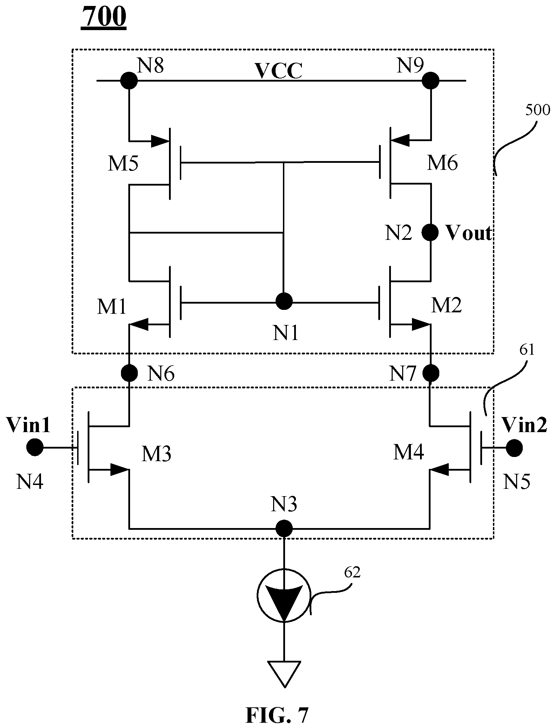

FIG. 7 is an embodiment of the amplifier shown in FIG. 6.

Referring to FIG. 7, in an exemplary embodiment of the disclosure, a second port of the current source 62 is grounded, the first output port of the input structure 61 is connected to the sixth node N6, the second output port of the input structure is connected to the seventh node N7. Both the eighth node N8 and the ninth node N9 of the output structure 500 are connected to the power supply VCC. The first input port (the fourth node N4) and the second input port (the fifth node N5) of the input structure 61 respectively, as the first input port and the second input port of the amplifier 600 respectively, are connected to the first input voltage Vin1 and the second input voltage Vin2, the first port of the current source 62 is connected to the fifth port (the third node N3) of the input structure 61.

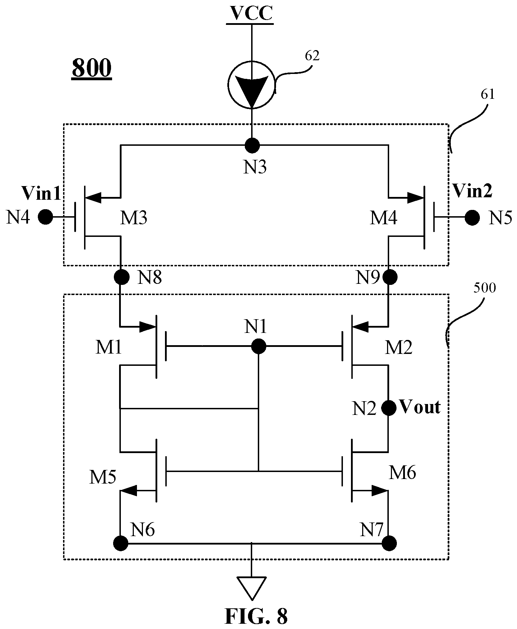

FIG. 8 is another embodiment of the amplifier shown in FIG. 6.

Referring to FIG. 8, in another embodiment of the disclosure, the second port of the current source 62 is connected to the power supply VCC, the first output port of the input structure 61 is connected to the eighth node N8, the second output port of the input structure is connected to the ninth node N9. Both the sixth node N6 and the seventh node N7 of the output structure 500 are grounded. The first input port (the fourth node N4) and the second input port (the fifth node N5) of the input structure 61, respectively as the first input port and the second input port of the amplifier 600, are connected to the first input voltage Vin1 and the second input voltage Vin2, the first port of the current source 62 is connected to the fifth port (the third node N3) of the input structure 61.

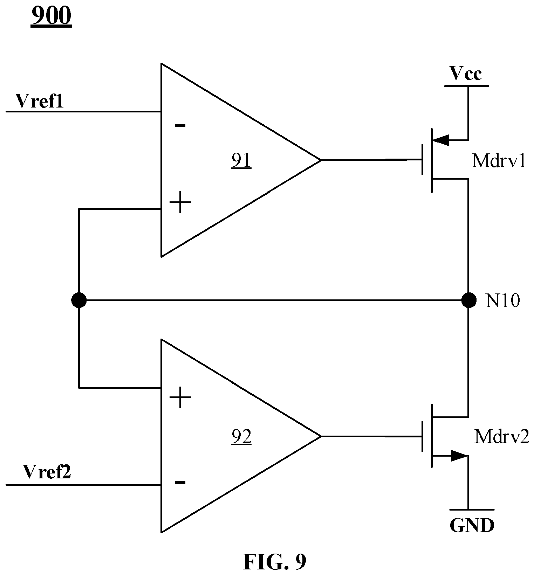

FIG. 9 is a schematic diagram of a driving circuit provided by an embodiment of the disclosure.

Referring to FIG. 9, a driving circuit 900 may include a first amplifier 91, a second amplifier 92, a first driving transistor Mdrv1 and a second driving transistor Mdrv2.

The first amplifier 91 is an amplifier (200, 300, 400, 600, 700, 800) as described above, a first input terminal is connected to a first reference voltage Vref1, and a second input terminal is connected to the tenth node N10.

The second amplifier 92 is an amplifier (200, 300, 400, 600, 700, 800) as described above, a first input terminal is connected to a second reference voltage Vref2, and a second input terminal is connected to the tenth node N10.

A gate of the first driving transistor Mdrv1 is connected to an output terminal of the first amplifier 91, a source of the first driving transistor Mdrv1 is connected to the power supply VCC, and a drain of the first driving transistor Mdrv1 is connected to the tenth node N10.

A gate of the second driving transistor Mdrv2 is connected to an output terminal of the second amplifier 92, a source of the second driving transistor Mdrv2 is grounded, and a drain of the second driving transistor Mdrv2 is connected to the tenth node N10. The tenth node N10 serves as an output terminal of the driving circuit 900.

In the embodiments of the disclosure, the first amplifier 91 and the second amplifier 92 may be the same with each other or different from each other, as long as the amplifiers provided in the above-mentioned embodiments all fall within the protection scope of the disclosure.

In the embodiment shown in FIG. 9, the first driving transistor Mdrv1 is a P-type transistor, and the second driving transistor Mdrv2 is an N-type transistor. Therefore, the first input terminal of the first amplifier 91 is an inverting input terminal, and the second input terminal of the first amplifier is a non-inverting input terminal. The first input terminal of the second amplifier 92 is an inverting input terminal, and the second input terminal of the second amplifier is a non-inverting input terminal.

In an embodiment of the disclosure, the first reference voltage Vrefl is not equal to the second reference voltage Vref2, and in this case, the first reference voltage Vref1>the output voltage Vout>the second reference voltage Vref2. In order to make the P-type first driving transistor Mdrv1 pull up the tenth node N10, the inverting input terminal of the first amplifier 91 is configured to be connected to the first reference voltage Vref1, and the non-inverting input terminal is connected to the tenth node N10. In order to make the N-type second driving transistor Mdrv2 pull down the tenth node N10, the inverting input terminal of the first amplifier 91 is configured to be connected to the second reference voltage Vref2, and the non-inverting input terminal of the first amplifier is connected to the tenth node N10.

In another embodiment, the first reference voltage Vrefl is equal to the second reference voltage Vref2, and in this case, Vref1=Vout=Vref2.

In an exemplary embodiment of the disclosure, the first driving transistor Mdrv1 and the second driving transistor Mdrv2 are both N-type transistors or are both P-type transistors. At this time, the first input terminal and the second input terminal of the first amplifier 91 or the second amplifier 92 may be defined according to the type of transistor to which the first amplifier or the second amplifier is connected.

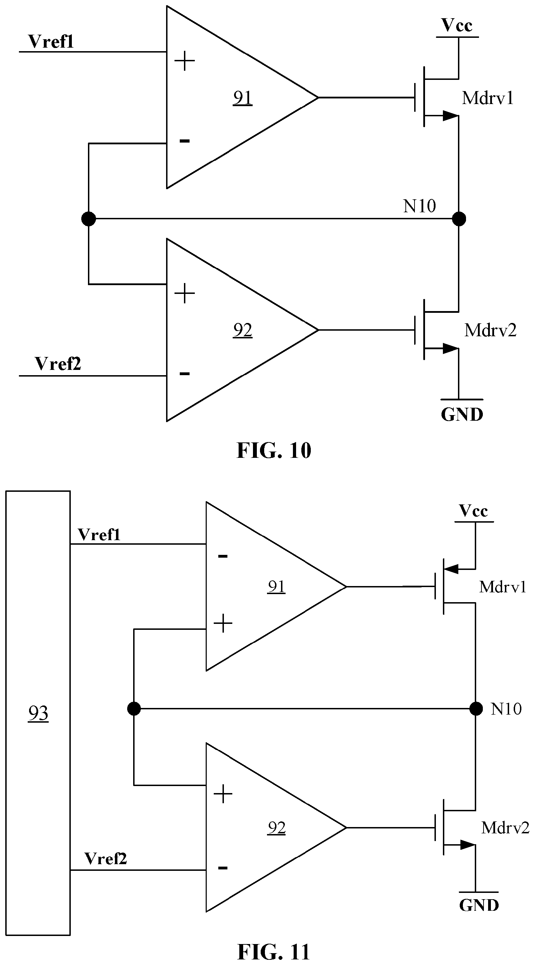

FIG. 10 is a schematic circuit diagram of a first driving transistor and a second driving transistor in an embodiment of the disclosure.

Referring to FIG. 10, when the first driving transistor Mdrv1 and the second driving transistor Mdrv2 are both set to be N-type transistors, the non-inverting input terminal of the first amplifier 91 is connected to the tenth node N10, and the inverting input terminal of the first amplifier is connected to the first reference voltage Vrefl. In this case, the first input terminal of the first amplifier 91 is the non-inverting input terminal, and the second input terminal of the first amplifier is the inverting input terminal, the first input terminal of the second amplifier 92 is the inverting input terminal, and the second input terminal of the second amplifier is the non-inverting input terminal.

FIG. 11 is a schematic diagram of a driving circuit in an embodiment of the disclosure.

Referring to FIG. 11, in an exemplary embodiment of the disclosure, the driving circuit further includes a reference voltage generation circuit 93.

The reference voltage generation circuit 93 is configured to generate the first reference voltage Vrefl and the second reference voltage Vref2. Both the first reference voltage Vrefl and the second reference voltage Vref2 can be regulated.

The reference voltage generation circuit 93 may be formed by a voltage dividing circuit composed of a plurality of resistances, and reference voltages are derived from different nodes of the voltage dividing circuit, to flexibly regulate the values of the first reference voltage Vrefl and the second reference voltage Vref2. In practice, the reference voltage generation circuit 93 may further have a plurality of solutions, which is not limited in the disclosure.

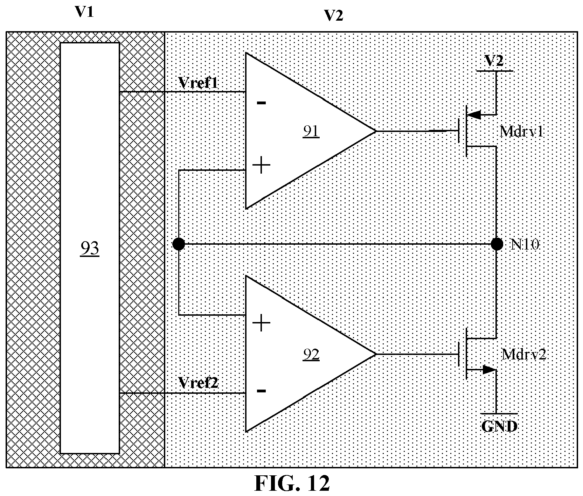

FIG. 12 is a schematic diagram of a driving circuit in yet another embodiment of the disclosure.

Referring to FIG. 12, in an embodiment, the first amplifier 91, the second amplifier 92, the first driving transistor Mdrv1, and the second driving transistor Mdrv2 are all powered by a first power source V1, and the reference voltage generation circuit 92 is powered by a second power source V2. A voltage value of the first power source V1 may be greater than a voltage value of the second power source V2. In this case, the first transistor Mdrv1 is connected to the second power source V2.

A lower voltage is used to power the reference voltage generation circuit 92 to generate the reference voltage, to further reduce the power consumption of the driving circuit.

Compared to related technologies, the driving circuit shown in FIG. 9 to FIG. 12 has lower power consumption since the driving circuit uses the amplifier in which a bias voltage is provided by the amplifier according to the embodiments of the disclosure.

In summary, in the embodiments of the disclosure, the bias voltage of the transistor in the circuit is provided by the transistor, Therefore, the amplification function can be realized after the bias circuit for providing the bias voltage in the related technologies is removed, thereby effectively reducing the power consumption of the circuit.

It is to be noted that although several modules or units of the device for operation execution are mentioned in the above detailed description, this division is not mandatory. In fact, according to the embodiments of the disclosure, the features and functions of two or more modules or units described above may be embodied in one module or unit. Conversely, features and functions of a module or unit described above may be further divided to be embodied by a plurality of modules or units.

Other embodiments of the disclosure are readily apparent to those skilled in the art upon consideration of the specification and practice of the disclosure disclosed herein. This disclosure is intended to cover any variations, uses, or adaptive changes of the disclosure. These variations, uses, or adaptive changes conform to the general principles of the disclosure and include common knowledge or conventional technical means in the technical field that are not disclosed in the disclosure. The specification and the embodiments are only regarded to be exemplary, and the true scope and concept of the disclosure are indicated by the claims.

### INDUSTRIAL APPLICABILITY

In the embodiments of the disclosure, the bias voltage of the transistor in the amplifier is provided by the transistor, thereby implementing the voltage amplification function without adding an external bias circuit, and reducing the power consumption of the amplifier.

## Claims

1. A cascode structure, wherein a bias voltage of a common-gate structure in the cascode structure is provided by the cascode structure, and the cascode structure has a first node, a second node, a third node, a fourth node and a fifth node.

2. The cascode structure of claim 1, wherein the common-gate structure of the cascode structure comprises:
a first transistor and a second transistor, wherein a gate and a drain of the first transistor and a gate of the second transistor all are connected to the first node, and a drain of the second transistor is connected to the second node.

3. The cascode structure of claim 2, wherein a common-source structure of the cascode structure comprises:
a third transistor and a fourth transistor, wherein a drain of the third transistor is connected to a source of the first transistor, and a drain of the fourth transistor is connected to a source of the second transistor, both a source of the third transistor and a source of the fourth transistor are connected to the third node, a gate of the third transistor is connected to the fourth node, and a gate of the fourth transistor is connected to the fifth node.

4. The cascode structure of claim 3, wherein the first transistor, the second transistor, the third transistor, and the fourth transistor are of the same type.

5. An amplifier, comprising:
the cascode structure of any one of claims 1 to 4, wherein the fourth node and the fifth node in the cascode structure serves as a first input port and a second input port of the amplifier, respectively;
a current source comprising two ports, wherein a first port of the current source is connected to the third node; and
a load structure comprising four ports, wherein a first port of the load structure is connected to the first node, a second port of the load structure is connected to the second node, and the second port of the load structure serves as an output port of the amplifier.

6. The amplifier of claim 5, wherein a transistor type of the current source is the same as a transistor type of the cascode structure.

7. The amplifier of claim 5, wherein the load structure comprises:
a fifth transistor and a sixth transistor, wherein a gate and a drain of the fifth transistor are both connected to a gate of the sixth transistor, the drain of the fifth transistor serves as the first port of the load structure, and a drain of the sixth transistor serves as the second port of the load structure, a source of the fifth transistor serves as a third port of the load structure, and a source of the sixth transistor serves as a fourth port of the load structure.

8. The amplifier of claim 5, wherein a transistor type in the load structure is different from a transistor type of the cascode structure.

9. The amplifier of claim 5, wherein a second port of the current source is grounded, and the third port and the fourth port of the load structure are both connected to a power source.

10. The amplifier of claim 5, wherein a second port of the current source is connected to a power source, and the third port and the fourth port of the load structure are both grounded.

11. An output structure, wherein bias voltages of transistors in the output structure are all provided by the output structure, the output structure comprises a first node, a second node, a sixth node, a seventh node, an eighth node, and a ninth node.

12. The output structure of claim 11, wherein the output structure comprises:
a first transistor, a second transistor, a fifth transistor and a sixth transistor, wherein a gate of the first transistor, a gate of the second transistor, a gate of the third transistor, a gate of the fourth transistor, a drain of the first transistor and a drain of the fifth transistor are all connected to the first node, a drain of the second transistor and a drain of the sixth transistor are both connected to the second node, a source of the first transistor is connected to the sixth node, and a source of the second transistor is connected to the seventh node, a source of the fifth transistor is connected to the eighth node, a source of the sixth transistor is connected to the ninth node, and the second node severs as an output port of the output structure.

13. The output structure of claim 12, wherein the first transistor and the second transistor are both N-type transistors, and the fifth transistor and the sixth transistor are both P-type transistors.

14. An amplifier, comprising:
the output structure of any one of claims 11 to 13, wherein an output port of the output structure serves as an output port of the amplifier;
an input structure comprising five ports, wherein a first output port and a second output port of the input structure are both connected to the output structure, and a first input port and a second input port of the input structure respectively serves as a first input port and a second input port of the amplifier; and
a current source comprising two ports, a first port of the current source is connected to a fifth port of the input structure.

15. The amplifier of claim 14, wherein a second port of the current source is grounded, the first output port of the input structure is connected to the sixth node, and the second output port of the input structure is connected to the seventh node, the eighth node and the ninth node of the output structure are both connected to a power source.

16. The amplifier of claim 14, wherein the second port of the current source is connected to a power supply, the first output port of the input structure is connected to the eighth node, and the second output port of the input structure is connected to the ninth node, the sixth node and the seventh node of the output structure are all grounded.

17. A driving circuit, comprising:
a first amplifier which is the amplifier of any one of claims 5 to 10 or claims 14 to 16, wherein a first input terminal of the first amplifier is connected to a first reference voltage, and a second input terminal of the first amplifier is connected to a tenth node;
a second amplifier which is the amplifier of any one of claims 5 to 10 or claims 14 to 16, wherein a first input terminal of the second amplifier is connected to a second reference voltage, and a second input terminal of the second amplifier is connected to the tenth node;
a first driving transistor, a gate of which is connected to an output terminal of the first amplifier, a source of which is connected to a power supply, and a drain of which is connected to the tenth node; and
a second driving transistor, a gate of which is connected to an output terminal of the second amplifier, a source of which is connected to the ground, and a drain of which is connected to the tenth node, the tenth node serving as an output terminal of the driving circuit.

18. The driving circuit of claim 17, wherein the first driving transistor is a P-type transistor, and the second driving transistor is an N-type transistor.

19. The driving circuit of claim 17, wherein the first driving transistor and the second driving transistor are both N-type transistors or are both P-type transistors.

20. The driving circuit of claim 17, wherein the first reference voltage is not equal to the second reference voltage.

21. The driving circuit of claim 17, further comprising:
a reference voltage generation circuit configured to generate the first reference voltage and the second reference voltage, wherein both the first reference voltage and the second reference voltage are regulatable.

22. The driving circuit of claim 21, wherein the first amplifier, the second amplifier, the first driving transistor and the second driving transistor are all powered by a first power source, and the reference voltage generation circuit is powered by a second power source.

23. The driving circuit of claim 22, wherein the voltage value of the first power source is greater than the voltage value of the second power source.
